(19) Europäisches Patentamt
European Patent Office
Office européen des brevets

(11) **EP 2 927 974 B1**

(12) **EUROPÄISCHE PATENTSCHRIFT**

(45) Veröffentlichungstag und Bekanntmachung des Hinweises auf die Patenterteilung:
**20.09.2017   Patentblatt 2017/38**

(51) Int Cl.:
***H01L 39/24*** *(2006.01)*

(21) Anmeldenummer: **15162340.2**

(22) Anmeldetag: **02.04.2015**

(54) **VERFAHREN ZUR HERSTELLUNG VON SUPRALEITERN MIT VERRINGERTER ABHÄNGIGKEIT DES KRITISCHEN STROMES VON AXIALER MECHANISCHER DREHUNG**

METHOD FOR MAKING SUPERCONDUCTORS WITH REDUCED DEPENDENCE OF THE CRITICAL CURRENT OF AXIAL MECHANICAL ROTATION

PROCÉDÉ DE PRODUCTION DE SUPRACONDUCTEURS AYANT UNE DÉPENDANCE RÉDUITE DU COURANT CRITIQUE DE ROTATION MÉCANIQUE AXIALE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.04.2014   DE 102014206429**

(43) Veröffentlichungstag der Anmeldung:
**07.10.2015   Patentblatt 2015/41**

(73) Patentinhaber: **Bruker BioSpin AG
8117 Fällanden (CH)**

(72) Erfinder: **Seeber, Bernd
1206 Genève (CH)**

(74) Vertreter: **Kohler Schmid Möbus Patentanwälte Partnerschaftsgesellschaft mbB
Gropiusplatz 10
70563 Stuttgart (DE)**

(56) Entgegenhaltungen:
**WO-A1-2011/061537     JP-A- 2013 174 038
US-A1- 2009 206 974**

**Beschreibung**

Die Erfindung betrifft ein Verfahren zur Herstellung eines supraleitenden Drahtes mit einer Vielzahl von supraleitenden Filamenten, die innerhalb einer elektrisch leitenden, aber nicht supraleitenden Matrix angeordnet sind, wobei zumindest einige supraleitende Filamente um die Drahtachse in einem Bereich von Verdrillungswinkeln verdrillt werden.
Ein solches Verfahren ist an sich bekannt, etwa aus Referenz [4].

Hintergrund der Erfindung und sonstiger Stand der Technik

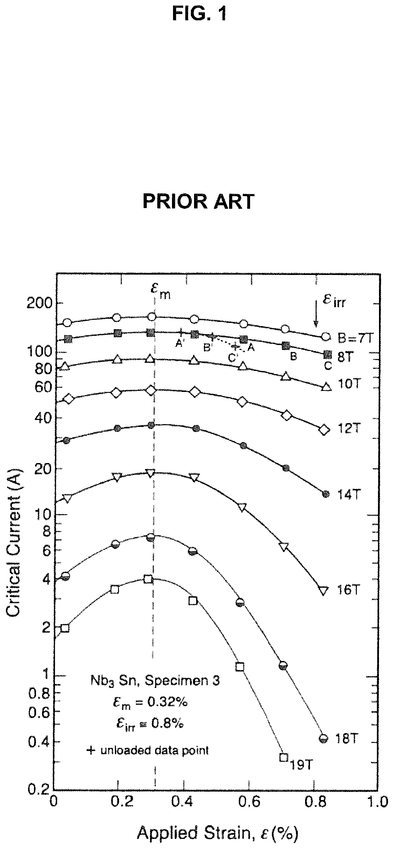

Die Erfindung beschreibt ein Verfahren zur Herstellung eines mehrkernigen supraleitenden Drahtes, in dem die Verdrillung der supraleitenden Filamente gezielt um eine optimale Verdrillungslänge angeordnet ist. Unter Verdrillungslänge versteht man die Länge über die die Filamente innerhalb eines Drahtes eine Rotation von 360° durchführen. Eine optimale Verdrillungslänge bewirkt, dass bei Supraleitern mit großer Empfindlichkeit des kritischen Stromes gegenüber axialer mechanischer Dehnung diese reduziert werden kann. Weil dadurch die für den Magnetbau erforderlichen Drahtlängen (und entsprechend die Kosten) reduziert werden, ist dies von großer technologischer Bedeutung.
In der JP 2013 174038 A (=Referenz [9]) geht es um die Fabrikation und Anwendung von Bänder und Matten aus Nanofibern und um verdrillte oder nicht verdrillte Nanofiber-Garn, was mit dem erfindungsgemäßen Herstellungsverfahren für einen supraleitenden Draht nichts zu tun hat. Die dort beschriebene Verdrillung der Nanofibern in einem Garn dient zu einer Reduzierung der Steifheit des Garns in Richtung des Garns und soll große reversible Änderungen der Länge in Richtung des Garns ermöglichen.
Die WO 2011/061537 A1 (=Referenz [10]) bezieht sich auf die Verbesserung der Feldqualität von Multipolmagnete für Teilchenbeschleuniger. Im Besonderen geht es um die Verbesserung des Doppelten-Helix-Konzepts. Es handelt sich dabei um die Anordnung eines Einzelleiters oder Kabels beim Bau eines Multipolmagneten.
Bei der US 2009/206974 A1 (=Referenz [11] geht es um die Anordnung von Einzelleitern beim Bau eines Magneten. Dadurch soll ein Magnet kompakter und billiger hergestellt werden können. Es wird kein spezieller Unterschied gemacht zwischen einem normalleitenden und einem supraleitenden Einzelleiter (Draht).
Ausdrücklich sei darauf hingewiesen, dass zwischen der Verdrillung der supraleitenden Filamente innerhalb eines als Einzelleiter vorliegenden supraleitenden Drahtes und der Verdrillung einer Vielzahl von supraleitenden Drähten, also vielen Einzelleitern, in einem Kabel unterschieden werden muss. Die vorliegende Erfindung beschäftigt sich mit der Verdrillung der supraleitenden Filamente innerhalb eines supraleitenden Drahtes (=Einzelleiter).
Als Beispiel kann der derzeit meist eingesetzte technische Supraleiter für die Erzeugung höchster Magnetfelder $Nb_3Sn$ genannt werden. Der kritische Strom bei 4.2 Kelvin als Funktion der angewandten axialen Dehnung ist in Figur 1 dargestellt (siehe Referenz [1]). Bei einem Magnetfeld von 7 Tesla ist die Abhängigkeit des kritischen Stromes von der axialen Dehnung relativ gering. Mit zunehmendem Magnetfeld nimmt jedoch die Empfindlichkeit des kritischen Stromes mit der Dehnung stark zu. Zum Beispiel im Fall von 19 Tesla kommt es bei kleiner Dehnung zu einem reversiblen Anstieg des kritischen Stromes von ca. 100% (!), gefolgt von einer anschließenden Reduzierung gegen Null.
In einem Magneten ist der supraleitende Draht großen elektromagnetischen Kräften (Lorentz Kräften) ausgesetzt. Wegen dieser Kräfte und der daraus resultierenden Dehnung ändert sich der kritische Strom des Supraleiters. Wie aus Figur 1 ersichtlich, ist die Änderung des kritischen Stroms bei hohen Magnetfeldern besonders ausgeprägt. Ein Magnethersteller muss dieses Verhalten bei der Konzeption und dem Bau eines Magneten berücksichtigen.
Die vorliegende Erfindung ermöglicht nun durch ein spezielles Herstellungsverfahren, den kritischen Strom weitgehend von der axialen
Dehnung unabhängig zu machen. Dazu muss etwas näher auf die physikalischen Grundlagen des Verhaltens eingegangen werden:

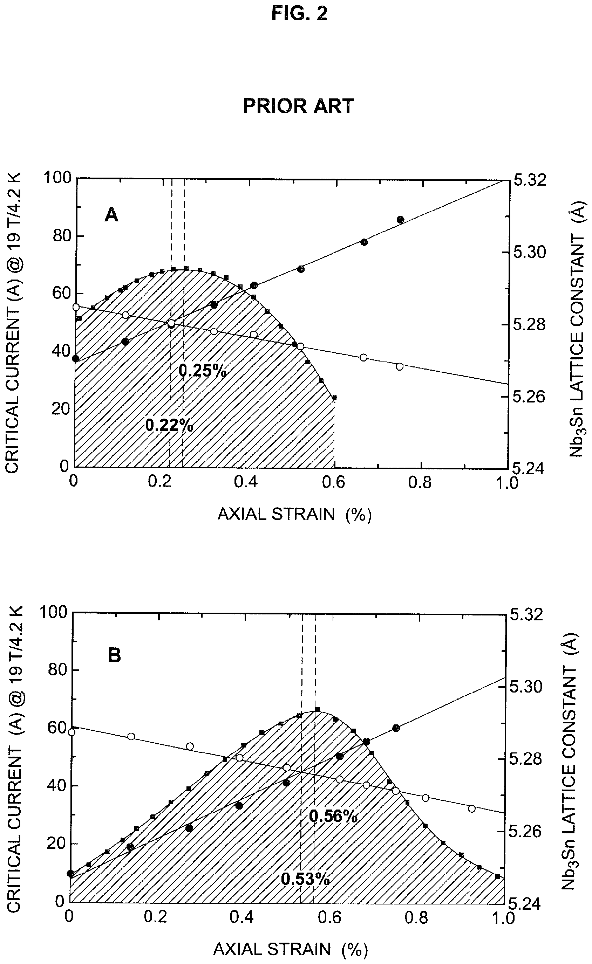

In einer kürzlich veröffentlichten Arbeit gelang es die kristallographische Gitterkonstante von $Nb_3Sn$ innerhalb eines Drahtes als Funktion der Dehnung bei 4.2 Kelvin zu messen (siehe Referenz [2]). Entscheidend für dieses Experiment war der Einsatz einer hochenergetischen Röntgenstrahlung, wie sie bei der Europäischen Synchrotron Strahlenquelle (ESRF) in Grenoble zur Verfügung steht. Untersucht wurde ein $Nb_3Sn$ Draht, der mittels des bekannten internen Zinn Prozesses hergestellt wurde (*Oxford Instruments Superconducting Technology*). Der Draht hat einen Durchmesser von 0.81 mm und die supraleitenden Filamente sind verdrillt (Verdrillungslänge = 15 mm). Die Spannungs- Dehnungskurve des Drahtes wurde bei 4.2 Kelvin aufgenommen und in-situ die Gitterkonstanten der im Leiter gegenwärtigen Materialien, insbesondere von $Nb_3Sn$ gemessen. Zusätzlich wurde derselbe Leiter mit einem Stahlmantel (AISI 316L) versehen um den Einfluss einer thermischen Kompression (axial und radial) zu studieren. In einem unabhängigen Experiment wurde der kritische Strom als Funktion der Dehnung gemessen. In Figur 2 sind die Ergebnisse zusammengefasst.

Bei Nulldehnung ist das kubische $Nb_3Sn$ Gitter verzerrt: in axialer Richtung ist eine Verkleinerung der Gitterkonstanten (Kompression) und in radialer Richtung eine Vergrößerung zu beobachten. Mit zunehmender axialer Dehnung wird die Verzerrung des kubischen Gitters linear verkleinert und verschwindet bei einem bestimmten Dehnungswert. Im Falle des hier untersuchten $Nb_3Sn$ Leiters ist die äußere Dehnung für ein kubisches (nicht verzerrtes) $Nb_3Sn$ Gitter 0.22% (Figur 2A). Wird derselbe Leiter mit einem Stahlmantel umgeben ist die Verzerrung des kubischen $Nb_3Sn$ Gitters bei Nulldehnung größer. Der Grund dafür ist, dass beim Abkühlen des Supraleiters auf 4.2 Kelvin die thermische Kontraktion des Stahlmantels die des $Nb_3Sn$ Leiters übertrifft und dadurch eine zusätzliche Kompression entsteht. Um die Gitterverzerrung aufzuheben braucht es eine axiale Dehnung von 0.53% (Figur 2B).

In beiden Fällen (mit und ohne Stahlmantel) erreicht der kritische Strom seinen Maximalwert bei einem nichtverzerrtem, also kubischen $Nb_3Sn$ Gitter. Die beobachtete Verschiebung des maximalen kritischen Stroms in Bezug auf das rein kubische $Nb_3Sn$ Gitter (+0.03%) ist bedingt durch die Verdrillung der supraleitenden Filamente. Wegen der Verdrillung sind nicht alle der stromtragenden Filamente parallel zur äußeren Dehnung. Aus diesem Grund ist die Dehnung bei nicht parallelen Filamenten reduziert was zu einer Änderung des kritischen Stroms führt.

Besonders bemerkenswert ist der Einfluss eines Stahlmantels der zu einer zusätzlichen Verzerrung des $Nb_3Sn$ beiträgt und dadurch den kritischen Strom von 67 A (Maximalwert) auf 10 A (!) bei Nulldehnung reduziert. Das Verhalten ist im gezeigten Dehnungsintervall bis 1% reversibel.

Für den Magnethersteller ist das Verhalten des supraleitenden Drahtes wie in Figuren 1 und 2 dargestellt (Stand der Technik). Um die Stromtragfähigkeit eines supraleitenden Drahtes vs. Magnetfeld besser auszunutzen, werden Solenoid Magnete in Sektionen unterteilt. Die dem höchsten Magnetfeld ausgesetzte Sektion wird mit einem Supraleiter von größerem Querschnitt gewickelt. Mit abnehmender Magnetfeldstärke kann der Supraleiter Querschnitt verringert werden (siehe Referenz [3]). Es gibt aber auch Anwendungen bei denen es schwierig ist, wenn nicht gänzlich ausgeschlossen, den Magneten in Sektionen zu unterteilen (z.B. Multipolmagnete für die Hochenergiephysik, Magnete für Fusionsreaktoren). Bezüglich der Stromtragfähigkeit ist dann der supraleitende Draht nur in einem kleinen Teil des Magneten voll beansprucht und in anderen Teilen überdimensioniert. Bei größeren Magnetsystemen spielen zusätzlich die enormen elektromagnetischen Kräfte eine wichtige Rolle. Die Magnetwindungen müssen dann durch eine mechanische Verstärkung geschützt werden.

Ebenfalls aus dem Stand der Technik bekannt ist die Verdrillung der supraleitenden Filamente. Diese ist erforderlich um den Supraleiter bei zeitlich sich änderndem Magnetfeld (z.B. beim Laden oder Entladen einer Magnetspule) stabil zu halten. Physikalisch gesehen entsteht in einem zeitlich sich ändernden Magnetfeld zwischen den Filamenten eine elektrische Spannung, welche die Ursache von Kopplungsströmen zwischen den Filamenten ist. Da diese über die elektrisch leitende, aber nicht supraleitende Matrix fließen, kommt es zu einer Erwärmung. Eine Möglichkeit, derartige Kopplungsströme zu reduzieren, ist die Verdrillung der Filamente. Vereinfacht ausgedrückt kompensieren sich die induzierten Spannungen über eine Verdrillungslänge (Rotation eines Filaments um 360°). Die kritische Verdrillungslänge kann mittels nachstehender Beziehung ermittelt werden (siehe Referenz [4]).

$$I_c = \sqrt{\frac{2\rho J_c d}{\mu_0 dH/dt}}$$

$I_c$ ist die kritische Verdrillungslänge, $\rho$ ist der spezifische elektrische Widerstand der normalleitenden Matrix, $J_c$ ist die Stromdichte des Supraleiters, $d$ ist der Durchmesser des supraleitenden Filaments und $\mu_0 dH/dt$ ist die zeitliche Änderung eines senkrecht zum supraleitenden Draht angelegten Magnetfeldes. Für einen $Nb_3Sn$ Supraleiter ergibt sich nun mit $\rho = 4.10^{-8}$ $\Omega$m (Kupfer-Zinn Bronze), $J_c = 8.10^8$ $A/m^2$, d = $5.10^{-6}$ m und einem $\mu_0 dH/dt$ zwischen $10^{-3}$ und $10^{-1}$ T/s eine kritische Verdrillungslänge von 0,566 m und 0,057 m.

Die kritische Verdrillungslänge ist eine Obergrenze und sollte in der Praxis wesentlich darunter liegen. Als praktisches Beispiel kann der TF-ITER Leiter angeführt werden (TF-ITER = Toroidal Field - International Thermonuclear Experimental Reactor). Bei einem Drahtdurchmesser von 0.81 mm beträgt die Verdrillungslänge 15 mm. Das entspricht in etwa einem Viertel der oben zitierten kritischen Verdrillungslänge bei einer Feldänderungsrate von $10^{-1}$ T/s.

Für die Reduzierung der oben zitierten Kopplungsströme zwischen den Filamenten kann der maximale Verdrillungswinkel der Filamente in Bezug auf die Drahtachse nach folgender Beziehung bestimmt werden:

$$\tan\theta = \frac{\pi D}{I_\rho}$$

D ist der Drahtdurchmesser (besser der Durchmesser auf dem die äußeren Filamente innerhalb des Drahtes liegen) und $I_\rho$ ist die reale Verdrillungslänge. In der Praxis ergeben sich nun maximale Verdrillungswinkel bis etwa 10°-15°. Eine obere Grenze stellt ein Supraleiter für 50/60 Hz Wechselstromanwendung dar, bei dem Verdrillungswinkel bis 25° auftreten (siehe Referenz [5]).

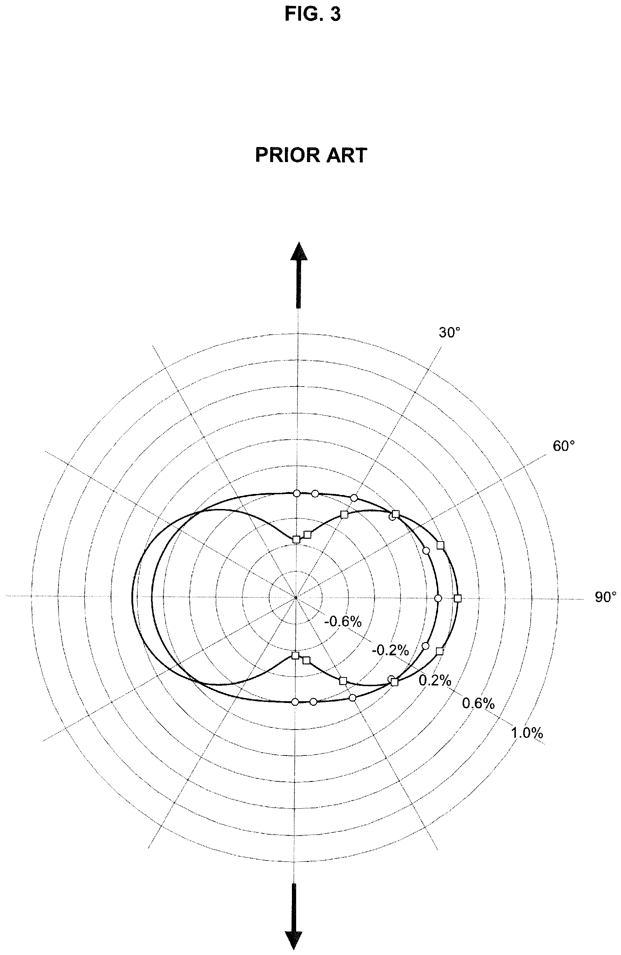

Es gibt nun eine Möglichkeit, die Dehnungsabhängigkeit des kritischen Stromes eines $Nb_3Sn$ Supraleiters wesentlich zu verbessern, was Gegenstand der vorliegenden Erfindung ist. Dazu ist es sinnvoll, die Verzerrung des $Nb_3Sn$ Gitters nicht nur in axialer und radialer Richtung zu untersuchen. Das oben zitierte Synchrotronstrahlenexperiment erlaubt die Messung der $Nb_3Sn$ Gitterkonstanten in beliebiger Richtung (siehe Referenz [3]). Ein Beispiel dafür ist in Figur 3 illustriert, wo die Verzerrung (Dehnung) des $Nb_3Sn$ Gitters nach dem Abkühlvorgang auf 4.2 Kelvin, also ohne von außen wirkende Dehnung, in verschiedenen Richtungen gemessen wurde. Bemerkenswert ist die axiale Kompression des $Nb_3Sn$ in der Drahtachse (-0.53%) im Falle eines Stahlmantels. Ohne letzteren beträgt die Kompression -0.22%. Nachdem die supraleitenden Filamente weitgehend parallel zur Drahtachse angeordnet sind (wegen der Verdrillung besteht eine maximale Abweichung von 10°), wird der kritische Strom beeinflusst. Bei 4.2 Kelvin und einem Magnetfeld von 19 Tesla ist der kritische Strom 51 A ohne Stahlmantel und 10 A (!) mit Stahlmantel (ebenfalls ersichtlich in den Figuren 2A und 2B).

Die Winkelabhängigkeit der $Nb_3Sn$ Gitterdehnung kann modelliert werden (siehe Referenz [6]). Unter der Voraussetzung, dass die Gitterdehnung in axialer Drahtrichtung, $\varepsilon_{ax0}$, und in radialer Drahtrichtung, $\varepsilon_{rad0}$, durch Messung bekannt sind, kann diese unter anderen Winkel, $\theta$, berechnet werden:

$$\varepsilon(\theta) = \sqrt{\left(1 + \varepsilon_{ax0}\right)^2 \sin^2\theta + \left(1 + \varepsilon_{rad0}\right)^2 \cos^2\theta} - 1$$

Wie aus Figur 3 hervorgeht, werden die experimentell ermittelten Gitterdehnungen durch diese Funktion sehr gut beschrieben.

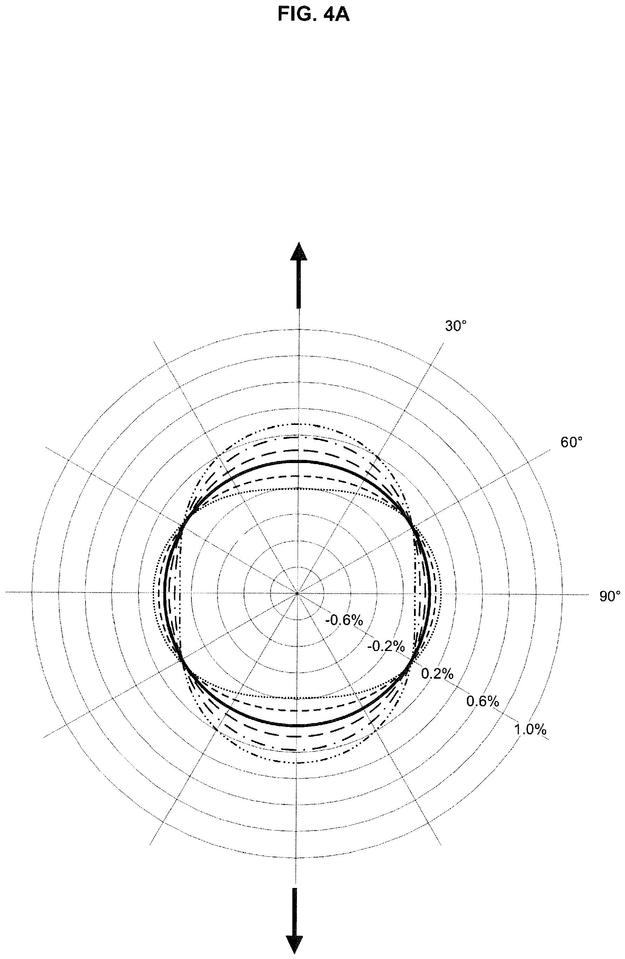

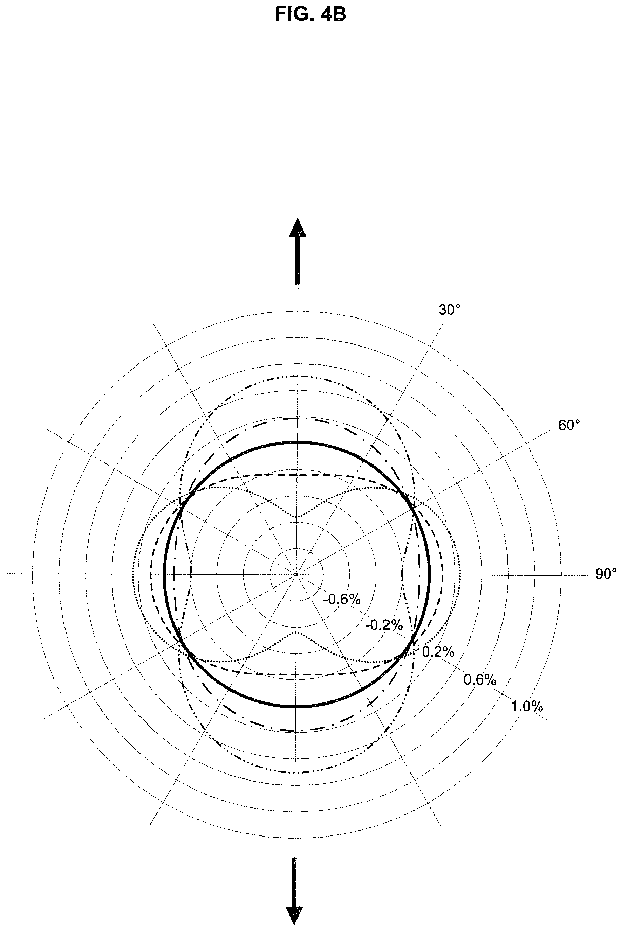

Man kann nun die Winkelabhängigkeit der Gitterdehnung als Funktion der axialen Dehnung berechnen. Unter Benutzung der in Figur 2 gefundenen Gitterdehnung in axialer Drahtrichtung, $\varepsilon_{ax0}$, und in radialer Drahtrichtung, $\varepsilon_{rad0}$, wurden die Figuren 4A und 4B berechnet. Dabei können nachstehende Erkenntnisse gewonnen werden:

Für einen $Nb_3Sn$ Draht ohne Stahlmantel ist bei Anwendung einer externen axialen Dehnung von 0.22% die Verzerrung des kubischen $Nb_3Sn$ Gitters aufgehoben (siehe auch Figur 2A). Anders ausgedrückt ist die Gitterdehnung in allen Richtungen null. Im Falle eines $Nb_3Sn$ Drahts mit Stahlmantel braucht es eine externen axialen Dehnung von 0.53% um ein rein kubischen $Nb_3Sn$ Gitter zu erhalten (siehe auch Figur 2B). Neu ist nun die Tatsache, dass unabhängig von der externen axialen Dehnung unter einem bestimmten Winkel keine Gitterverzerrung auftritt. Für einen $Nb_3Sn$ Draht ohne Stahlmantel ist dieser Winkel in Bezug auf die Drahtachse 58° $\pm$ 2° (Figur 4A) und für einen Draht mit Stahlmantel 55° $\pm$ 5° (Figur 4B).

Wie aus Figur 2 ersichtlich, hat der kritische Strom einen maximalen Wert für ein rein kubisches $Nb_3Sn$ Gitter, also ohne Verzerrung. Berücksichtigt man, dass die Filamente eines $Nb_3Sn$ Drahtes verdrillt sind, ergibt sich nun die Möglichkeit, die Verdrillungslänge so einzustellen, dass die Mehrzahl der Filamente in der Nähe von 58° zu liegen kommen. Damit kann die Abhängigkeit des kritischen Stromes von einer externen axialen Dehnung stark reduziert werden. Dies ist genau der Gegenstand der vorliegenden Erfindung.

Aufgabe der Erfindung

Der vorliegenden Erfindung liegt demgegenüber die Aufgabe zugrunde, ein Verfahren der eingangs definierten Art vorzustellen, in welchem es mit möglichst einfachen technischen Mitteln gelingt, die starke Abhängigkeit des kritischen Stroms eines supraleitenden Drahts bei hohen Magnetfeldern als Funktion einer axialen Dehnung wesentlich zu reduzieren. Des Weiteren soll die Erfindung bewirken, dass bei einer entsprechenden Anordnung der supraleitenden Filamente die Abhängigkeit des kritischen Stroms eines supraleitenden Drahts bei hohen Magnetfeldern als Funktion einer axialen Dehnung weitgehend aufgehoben werden kann.

Kurze Beschreibung der Erfindung

Diese Aufgabe wird auf überraschend einfache Art und Weise sowie mit ohne Weiteres zur Verfügung stehenden technischen Mitteln gelöst durch eine Modifikation eines Verfahrens mit den eingangs genannten Merkmalen, die dadurch gekennzeichnet ist, dass die supraleitenden Filamente eines $Nb_3Sn$ Drahtes so verdrillt werden, dass die Mehrzahl der Filamente in Bezug auf die Drahtachse unter einem Verdrillungswinkel in der Nähe von 58° zu liegen kommen und dadurch die Abhängigkeit des kritischen Stromes des supraleitenden Drahtes von einer externen axialen Dehnung des Drahtes reduziert wird.

Das oben genannte Ziel der Erfindung wird dadurch erreicht, dass Filamente, die unter einem Winkel zur Drahtachse in der Nähe von 58° liegen, unabhängig von der axialen Dehnung fast keine Verzerrung des $Nb_3Sn$ Gitters erleiden und deshalb einen maximalen kritischen Strom aufweisen (siehe auch Figur 2 und Figur 4). Die Konsequenz ist, dass der kritische Strom des Gesamtleiters bei Anwendung des erfindungsgemäßen Verfahrens nur mehr gering von der axialen Dehnung abhängig ist.

Genaue Wirkungsweise der Erfindung und weitere Vorteile gegenüber dem Stand der Technik

Mit Hilfe des erfindungsgemäß modifizierten Verfahrens kann insbesondere im Vergleich zum nächstkommenden Stand der Technik das erste Mal Einfluss auf die Abhängigkeit des kritischen Stroms in hohen Magnetfeldern von einer axialen Dehnung genommen werden (siehe Referenz [1], [7] und [8]). Mit dem erfindungsgemäßen Verfahren kann der kritische Strom nahezu unabhängig von der axialen Dehnung auf seinem maximalen Wert gehalten werden. Das hat den großen Vorteil, dass bei einem Magneten bei gleichbleibendem Magnetfeld wesentlich weniger supraleitender Draht benötigt wird. Durch den höheren kritischen Strom sind weniger Windungen erforderlich. Neben einem ökonomischen Vorteil, also geringeren Kosten, kann ein Magnet dadurch auch deutlich kompakter gebaut werden. Eine kompakte Bauweise verringert die auf den Supraleiter wirkenden elektromagnetischen Kräfte, was ebenfalls einen erheblichen Vorteil bei der Konzeption und dem Bau von supraleitenden Magnetsystemen darstellt.

Bevorzugte Ausführungsformen der Erfindung

Ganz besonders bevorzugt ist eine Variante des erfindungsgemäßen Verfahrens, die dadurch gekennzeichnet ist, dass die supraleitenden Filamente so verdrillt werden, dass die Mehrzahl der Filamente in Bezug auf die Drahtachse unter einem Verdrillungswinkel um 58° zu liegen kommen. Damit wird die Verzerrung des kristallographischen Gitters der stromtragenden Filamente unabhängig von einer äußeren axialen Dehnung (siehe auch Figur 4A). Ein derartiges Verhalten ist vorteilhaft für einen maximalen kritischen Strom des Gesamtleiters, der dann nahezu unabhängig von einer äußeren axialen Dehnung ist (siehe auch Figur 2). Dadurch ist der supraleitende Draht in einem Magneten wesentlich besser ausgenützt, was einer Reduzierung der benötigten Drahtlänge und damit vor allem auch der Kosten gleichkommt.

Eine weitere vorteilhafte Variante des erfindungsgemäßen Verfahrens zeichnet sich dadurch aus, dass als Material des supraleitenden Drahtes $Nb_3Sn$ oder ein Material mit ähnlichem Verhalten des kritischen Stromes als Funktion einer axialen Dehnung wie $Nb_3Sn$ gewählt wird. Auch damit wird die Verzerrung des kristallographischen Gitters der stromtragenden Filamente unabhängig von einer äußeren axialen Dehnung (siehe auch Figur 4A). Ein derartiges Verhalten ist vorteilhaft für einen maximalen kritischen Strom, der dann nahezu unabhängig von einer äußeren axialen Dehnung ist (siehe auch Figur 2). Dadurch ist der supraleitende Draht in einem Magneten wesentlich besser ausgenützt, was wiederum einer Reduzierung der benötigten Drahtlänge und Kosten gleichkommt.

Bevorzugt ist auch eine Verfahrensvariante, bei welcher der supraleitende Draht entweder extern oder intern mechanisch verstärkt wird. Im Falle einer externen Verstärkung eines $Nb_3Sn$ Supraleiters mit Edelstahl (AISI 316L) ist die Verzerrung des kristallographischen Gitters der stromtragenden Filamente unter einem Verdrillungswinkel von 55° unabhängig von einer äußeren axialen Dehnung (siehe auch Figur 4B). Ein derartiges Verhalten ist wiederum vorteilhaft für einen maximalen kritischen Strom der dann nahezu unabhängig von einer äußeren axialen Dehnung ist (siehe auch Figur 2), wodurch der supraleitende Draht in einem Magneten wesentlich besser ausgenützt ist, was einer Reduzierung der benötigten Drahtlänge und Kosten gleichkommt. Der optimale Verdrillungswinkel ergibt sich aus dem Querschnittverhältnis von Verstärkung/Supraleiter und daraus, ob die Verstärkung von außen oder von innen erfolgt.

Eine Klasse von Varianten des erfindungsgemäßen Verfahrens zeichnet sich dadurch aus, dass die supraleitenden Filamente ringförmig angeordnet sind und dadurch der Anteil der Filamente, die den geforderten Verdrillungswinkel zur Drahtachse erfüllen, vergrößert wird. Auch mit dieser Verfahrensvariante wird die Verzerrung des kristallographischen Gitters der stromtragenden Filamente unabhängig von einer äußeren axialen Dehnung (siehe auch Figur 4A). Ein derartiges Verhalten ist wiederum vorteilhaft für einen maximalen kritischen Strom, der dann nahezu unabhängig von einer äußeren axialen Dehnung ist (siehe auch Figur 2). Dadurch ist der supraleitende Draht in einem Magneten wesentlich besser ausgenützt, was einer Reduzierung der benötigten Drahtlänge und Kosten gleichkommt.

Bei einer alternativen Klasse von Verfahrensvarianten werden die supraleitenden Filamente gebündelt und die Verdrillung innerhalb eines Bündels wird so gestaltet, dass der geforderte Winkelbereich der Verdrillungswinkel der Filamente zur Drahtachse erfüllt wird. Auch damit wird die Verzerrung des kristallographischen Gitters der stromtragenden Filamente unabhängig von einer äußeren axialen Dehnung mit den bereits oben geschilderten Vorteilen.

Vorteilhaft ist auch eine des erfindungsgemäßen Verfahrens, bei der der Verdrillungsvorgang im Anschluss an die Drahtherstellung durchgeführt wird.

Eine weitere bevorzugte Verfahrensvariante zeichnet sich dadurch aus, dass nach einem ersten Verdrillungsvorgang des Drahtes der Drahtdurchmesser reduziert wird, so dass die geforderte Durchmessertoleranz erfüllt wird.

Weiter ist es von Vorteil, wenn nach einem zweiten Verdrillungsvorgang des Drahtes der Drahtdurchmesser reduziert wird, so dass die geforderte Durchmessertoleranz erfüllt wird.

Eine bevorzugte Variante des erfindungsgemäßen Verfahrens schließlich ist dadurch gekennzeichnet, dass eine oder mehrere Erholungsglühungen durchgeführt werden, so dass größere Verdrillungswinkel erzielt werden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und der Zeichnung

Die Erfindung ist in der Zeichnung dargestellt und wird anhand von Ausführungsbeispielen näher erläutert.

Figur 1 stellt die Abhängigkeit des kritischen Stroms bei 4.2 Kelvin eines $Nb_3Sn$ Supraleiters als Funktion einer axialen Dehnung und des Magnetfeldes dar.

Figur 2 illustriert den kritischen Strom (⑤) bei 4.2 Kelvin und 19 Tesla eines $Nb_3Sn$ Supraleiters als Funktion einer axialen Dehnung. Gleichzeitig wird die Gitterkonstante des $Nb_3Sn$ in axialer (③) und radialer Richtung (④) dargestellt. Das Verhalten in Figur 2A entspricht einem $Nb_3Sn$ Supraleiter ohne Stahlmantel und in Figur 2B mit Stahlmantel.

Figur 3 zeigt die Verzerrung (Gitterdehnung) des $Nb_3Sn$ Gitters als Funktion des Winkels zur Drahtachse nach dem Abkühlvorgang auf 4.2 K und ohne axiale Dehnung. Die Pfeile geben die Richtung der Drahtachse an. Die Messpunkte beziehen sich auf einen $Nb_3Sn$ Supraleiter ohne (④) und mit Stahlmantel (⑥) und die durchgezogenen Linien zeigen die gute Übereinstimmung mit Modellrechnungen.

Figur 4 zeigt die berechnete Verzerrung (Gitterdehnung) des $Nb_3Sn$ Gitters als Funktion des Winkels zur Drahtachse und der axialen Dehnung. Die Pfeile geben die Richtung der Drahtachse an. Das Verhalten in Figur 4A entspricht einem $Nb_3Sn$ Supraleiter ohne Stahlmantel mit nachstehender axialer Dehnung: ·········· 0%, - - - 0.1%, 0.22%, -- 0.3%, -·-0.4% und -··· 0.5%. Figur 4B ist derselbe $Nb_3Sn$ Supraleiter mit Stahlmantel und einer axialen Dehnung von: ·········· 0%,-0.3%, - 0.53%, -·- 0.7% und -··· 1.0%.

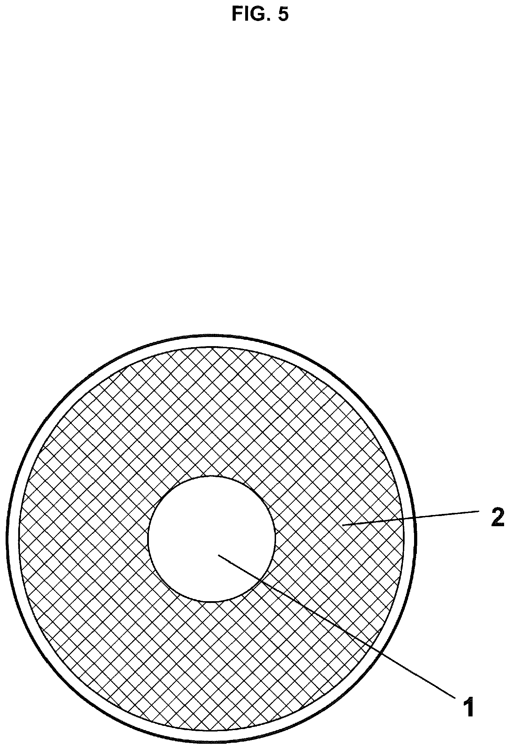

Figur 5 illustriert die Möglichkeit der Anordnung der supraleitenden $Nb_3Sn$ Filamente in einer ringförmigen Zone (2) um einen Drahtkern (1) was den Anteil der Filamente mit dem erforderlichen optimalen Verdrillungswinkel erhöht.

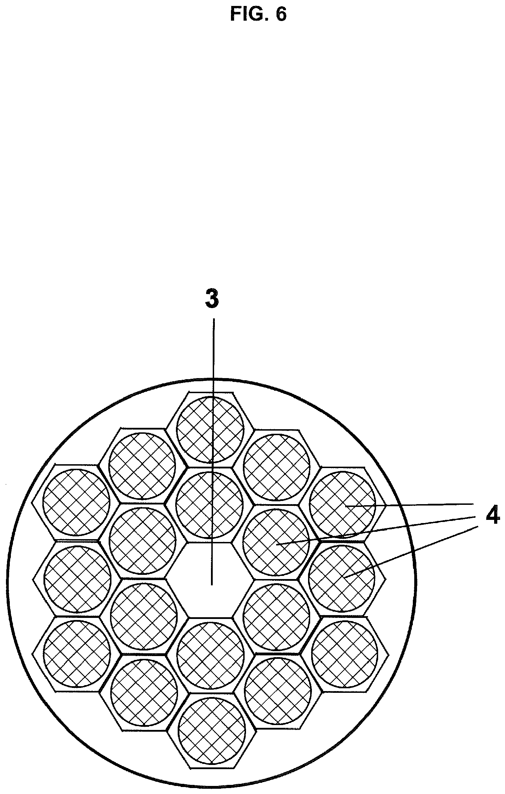

Figur 6 illustriert die Möglichkeit der Anordnung der supraleitenden $Nb_3Sn$ Filamente in Bündel (4) um einen Drahtkern (3). Damit ergibt sich eine zusätzliche Möglichkeit den Anteil der Filamente mit dem erforderlichen optimalen Verdrillungswinkel zu erhöhen.

**Beispiele**

Das erfinderische Verfahren kann nachfolgend anhand von Beispielen näher beschrieben werden.

Beispiel 1 - Die Herstellung eines $Nb_3Sn$ Drahtes, und zwar unabhängig vom Herstellungsprozess (Bronzeprozess, interner Zinn Prozess oder PIT Prozess), erfolgt wie üblich. Am Ende des Herstellungsprozesses werden die Filamente verdrillt. Die Verdrillungslänge wird dabei so eingestellt, dass die Mehrzahl der Filamente unter einem Winkel von ca. 58° zur Drahtachse zu liegen kommt.

Beispiel 2 - Da im Falle von Beispiel 1 die Filamente im Zentrum des Drahtes nicht verdrillt sind kann die Konzeption des Drahtes geändert werden. In diesem Fall sind die Filamente in einer konzentrischen Zone um die Drahtachse angeordnet (Figur 5). Anschließend erfolgt die Herstellung des $Nb_3Sn$ Drahtes, und zwar unabhängig vom Herstellungsprozess (Bronzeprozess, interner Zinn Prozess oder PIT Prozess), wie üblich. Am Ende des Herstellungsprozesses werden die Filamente verdrillt. Die Verdrillungslänge wird dabei so eingestellt dass die Mehrzahl der Filamente unter einem Winkel von ca. 58° zur Drahtachse zu liegen kommt.

Beispiel 3 - Eine andere Möglichkeit einen Verdrillungswinkel von ca. 58° zur Drahtachse zu erzielen ist die Unterteilung der Filamente in Bündel. In diesem Fall wird ein individuelles Bündel soweit verdrillt dass nach Ende des Herstellungsprozesses der geforderte Verdrillungswinkel von ca. 58° sich einstellt.

Beispiel 4 - Eine Verdrillung der Filamente um einen Winkel von 58° zur Drahtachse kann zu einer Variation des Drahtdurchmessers führen. Eine Variante des Verfahrens besteht nun darin dass der Draht nach einer ersten Verdrillung mit kleinem Verdrillungswinkel (kleiner als 58°) durch einen oder mehrere Drahtziehschritte im Durchmesser kalibriert wird. Anschließend wird der Verdrillungsprozess fortgesetzt.

Beispiel 5 - Durch den Verdrillungsprozess kann es zu einer Versprödung des Drahtes kommen. In diesem Fall müssen während des Verdrillungsprozess eine oder mehrere Entspannungsglühungen durchgeführt werden.

<u>Referenzliste</u>

[1] J. W. Ekin "Strain scaling law for flux pinning in practical superconductors. Part 1: Basic relationship and application to Nb3Sn conductors", Cryogenics, Volume 20, 1980, p. 613

[2] L. Muzzi et al. "Direct observation of Nb3Sn lattice deformation by high energy x-ray diffraction in internal-tin wires subject to mechanical loads at 4.2 K", Supercond. Sci. Technol., Volume 25, 2012, p. 05006

[3] M. N. Wilson "Superconducting magnets", Oxford University Press, 1983, p. 23

[4] M. N. Wilson et al. "Experimental and theoretical studies of filamentary superconducting composites. I. Basic ideas and theory" J. Phys. 3D, 1970, p. 1526

[5] P. Dubots et al. "NbTi wires with ultra-fine filaments for 50-60 Hz use: influence of the filament diameter upon losses", IEEE Trans. on Mag. Volume MAG-21, 1985, p. 177

[6] S. Awaji et al. "Angular dependence of residual strain in CuNb/(Nb, Ti)3Sn wires", Supercond. Sci. Technol. Volume 23, 2010, p. 105010

[7] A. Godeke "A review of the properties of Nb3Sn and their variation with A15 composition, morphology and strain state", Supercond. Sci. Technol., Volume 19, 2006, p. R77

[8] J. W. Ekin, "Unified scaling law for flux pinning in practical superconductors: I. Separability postulate, raw scaling data and prameterization at moderate strains" Supercond. Sci. Technol., Volume 23, 2010, p. 7

[9] JP 2013 174038 A

[10] WO 2011/061537 A1

[11] US 2009/206974 A1

**Patentansprüche**

1. Verfahren zur Herstellung eines supraleitenden Drahtes mit einer Vielzahl von supraleitenden Filamenten, die innerhalb einer elektrisch leitenden, aber nicht supraleitenden Matrix angeordnet sind, wobei zumindest einige supraleitende Filamente um die Drahtachse in einem Bereich von Verdrillungswinkeln verdrillt werden, **dadurch gekennzeichnet,** **dass** die Filamente eines $Nb_3Sn$ Drahtes derart verdrillt werden, dass a) die Mehrzahl der Filamente in Bezug auf die Drahtachse unter einem Verdrillungswinkel von 58° $\pm 2$° zu liegen kommen und der Draht nicht von einem Stahlmantel umgeben ist oder dass b) der $Nb_3Sn$ Draht von einem Stahlmantel umgeben ist und der Verdrillungswinkel der Filamente in Bezug auf die Drahtachse 55°$\pm 5$° beträgt und dadurch die Abhängigkeit des kritischen Stromes des supraleitenden Drahtes von einer externen axialen Dehnung des Drahtes reduziert wird.

2. Verfahren nach Anspruch 1, **dadurch gekennzeichnet, dass** der $Nb_3Sn$ Draht nicht von einem Stahlmantel umgeben ist und der Verdrillungswinkel der Filamente in Bezug auf die Drahtachse in der Nähe von 58° zu liegen kommt.

3. Verfahren nach einem der vorhergehenden Ansprüche, **dadurch gekennzeichnet, dass** als Material des supra-

leitenden Drahtes $Nb_3Sn$ oder ein Material mit ähnlichem Verhalten des kritischen Stromes als Funktion einer axialen Dehnung wie $Nb_3Sn$ gewählt wird.

4. Verfahren nach einem der vorhergehenden Ansprüche, **dadurch gekennzeichnet, dass** der supraleitende Draht entweder extern oder intern mechanisch verstärkt wird.

5. Verfahren nach einem der Ansprüche 1 bis 4, **dadurch gekennzeichnet, dass** die supraleitenden Filamente in einer ringförmigen Zone (2) um einen Drahtkern (1) herum angeordnet sind und dadurch der Anteil der Filamente, die den geforderten Verdrillungswinkel zur Drahtachse erfüllen, vergrößert wird.

6. Verfahren nach einem der Ansprüche 1 bis, **dadurch gekennzeichnet, dass** die supraleitenden Filamente in einem Bündel (4) um einen Drahtkern (3) herum angeordnet sind und die Verdrillung innerhalb eines Bündels (4) so gestaltet wird, dass der geforderte Winkelbereich der Verdrillungswinkel der Filamente zur Drahtachse erfüllt wird.

7. Verfahren nach einem der vorhergehenden Ansprüche, **dadurch gekennzeichnet, dass** der Verdrillungsvorgang im Anschluss an die Drahtherstellung durchgeführt wird.

8. Verfahren nach einem der vorhergehenden Ansprüche, **dadurch gekennzeichnet, dass** nach einem ersten Verdrillungsvorgang des Drahtes der Drahtdurchmesser reduziert wird, so dass die geforderte Durchmessertoleranz erfüllt wird.

9. Verfahren nach einem der vorhergehenden Ansprüche, **dadurch gekennzeichnet, dass** nach einem zweitem Verdrillungsvorgang des Drahtes der Drahtdurchmesser reduziert wird, so dass die geforderte Durchmessertoleranz erfüllt wird.

10. Verfahren nach einem der vorhergehenden Ansprüche, **dadurch gekennzeichnet, dass** eine oder mehrere Erholungsglühungen durchgeführt werden, so dass größere Verdrillungswinkel erzielt werden.


**Claims**

1. A method for manufacturing a superconducting wire having a plurality of superconducting filaments which are arranged within an electrically conducting but not superconducting matrix, wherein at least some of the superconducting filaments are twisted around the wire axis in a range of twist angles, **characterized in that** the filaments of an $Nb_3Sn$ wire are twisted so that

   a) the majority of the filaments comes to lie at an angle of twist of $58° \pm 2°$ relative to the wire axis and the wire is not surrounded by a steel jacket or that b) the $Nb_3SN$ wire is surrounded by a steel jacket and the twist angle of the filaments relative to the wire axis is $55° \pm 5°$, thereby reducing the dependency of the critical current of the superconducting wire on an external axial strain of the wire.

2. The method according to claim 1, **characterized in that** the $Nb_3Sn$ wire is not surrounded by a steel jacket and the twist angle of the filaments relative to the wire axis comes to lie around $58°$.

3. The method according to any one of the preceding claims, **characterized in that** $Nb_3Sn$ or a material having a similar behavior of the critical current as a function of an axial strain, such as $Nb_3Sn$, is selected as the material of the superconducting wire.

4. The method according to one of the preceding claims, **characterized in that** the superconducting wire is reinforced mechanically, either externally or internally.

5. The method according to one of claims 1 to 4, **characterized in that** the superconducting filaments are arranged in the form of an annular zone (2) around a wire core (1), thereby increasing the portion of filaments satisfying the required angle of twist relative to the wire axis.

6. The method according to one of claims 1 to 4, **characterized in that** the superconducting filaments are arranged in a bundle (4) around a wire core (3) and the twist within a bundle (4) is designed so that the required angle range of the twist angles of the filaments relative to the wire axis is satisfied.

7. The method according to one of the preceding claims, **characterized in that** the twisting process is carried out following the manufacture of the wire.

8. The method according to one of the preceding claims, **characterized in that** the wire diameter is reduced after a first wire twisting operation, so that the required diameter tolerance is satisfied.

9. The method according to one of the preceding claims, **characterized in that** the wire diameter is reduced after a second wire twisting operation, so that the required diameter tolerance is satisfied.

10. The method according to one of the preceding claims, **characterized in that** one or more recovery annealings are performed, so that larger angles of twist are achieved.

**Revendications**

1. Procédé de fabrication d'un fil supraconducteur comportant une pluralité de filaments supraconducteurs qui sont disposés à l'intérieur d'une matrice électriquement conductrice, mais non supraconductrice, dont au moins certains filaments supraconducteurs sont tordus dans une plage d'angle de torsion autour de l'axe du fil, **caractérisé en ce que** les filaments d'un fil de $Nb_3Sn$ sont tordus de telle sorte que a) la majorité des filaments présentent un angle de torsion de 58° $\pm$ 2° par rapport à l'axe du fil et le fil n'est pas entouré par une gaine en acier ou que b) le fil de $Nb_3Sn$ est entouré par une gaine en acier et l'angle de torsion des filaments est de 55° $\pm$ 5° par rapport à l'axe du fil et, de ce fait, la dépendance du courant critique du fil supraconducteur à une extension axiale externe du fil est réduite.

2. Procédé selon la revendication 1, **caractérisé en ce que** le fil de $Nb_3Sn$ n'est pas entouré par une gaine en acier et l'angle de torsion des filaments par rapport à l'axe du fil se situe autour de 58°.

3. Procédé selon l'une des revendications précédentes, **caractérisé en ce que** l'on choisit comme matériau du fil supraconducteur du $Nb_3Sn$ ou un matériau présentant un comportement du courant critique en fonction d'une extension axiale similaire à celui du $Nb_3Sn$.

4. Procédé selon l'une des revendications précédentes, **caractérisé en ce que** le fil supraconducteur est renforcé mécaniquement soit extérieurement, soit intérieurement.

5. Procédé selon l'une des revendications 1 à 4, **caractérisé en ce que** les filaments supraconducteurs sont disposés dans une zone annulaire (2) autour d'un noyau de fil (1) et, de ce fait, la part des filaments qui atteignent l'angle de torsion requis par rapport à l'axe du fil est augmentée.

6. Procédé selon l'une des revendications 1 à 5, **caractérisé en ce que** les filaments supraconducteurs sont groupés en faisceaux (4) autour d'un noyau de fil (3) et la torsion à l'intérieur d'un faisceau (4) est conçue de telle sorte que la plage angulaire requise des angles de torsion des filaments par rapport à l'axe du fil soit atteinte.

7. Procédé selon l'une des revendications précédentes, **caractérisé en ce que** l'opération de torsion est effectuée à la suite de la fabrication du fil.

8. Procédé selon l'une des revendications précédentes, **caractérisé en ce qu'**après une première opération de torsion du fil, le diamètre de fil est réduit afin d'atteindre la tolérance de diamètre requise.

9. Procédé selon l'une des revendications précédentes, **caractérisé en ce qu'**après une deuxième opération de torsion du fil, le diamètre de fil est réduit afin d'atteindre la tolérance de diamètre requise.

10. Procédé selon l'une des revendications précédentes, **caractérisé en ce qu'**un ou plusieurs recuits de régénération sont effectués afin d'atteindre des angles de torsion plus grands.

**FIG. 1**

**PRIOR ART**

## FIG. 2

## PRIOR ART

# FIG. 3

## PRIOR ART

30°

60°

90°

-0.6%

-0.2%

0.2%

0.6%

1.0%

## FIG. 4A

# FIG. 4B

FIG. 5

**FIG. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 2013174038 A
- WO 2011061537 A1
- US 2009206974 A1

**In der Beschreibung aufgeführte Nicht-Patentliteratur**

- **J. W. EKIN.** Strain scaling law for flux pinning in practical superconductors. Part 1: Basic relationship and application to Nb3Sn conductors. *Cryogenics,* 1980, vol. 20, 613
- **L. MUZZI et al.** Direct observation of Nb3Sn lattice deformation by high energy x-ray diffraction in internal-tin wires subject to mechanical loads at 4.2 K. *Supercond. Sci. Technol.,* 2012, vol. 25, 05006
- **M. N. WILSON.** Superconducting magnets. Oxford University Press, 1983, 23
- **M. N. WILSON et al.** Experimental and theoretical studies of filamentary superconducting composites. I. Basic ideas and theory. *J. Phys. 3D,* 1970, 1526
- **P. DUBOTS et al.** NbTi wires with ultra-fine filaments for 50-60 Hz use: influence of the filament diameter upon losses. *IEEE Trans. on Mag.,* 1985, vol. MAG-21
- **S. AWAJI et al.** Angular dependence of residual strain in CuNb/(Nb, Ti)3Sn wires. *Supercond. Sci. Technol.,* 2010, vol. 23, 105010
- **A. GODEKE.** A review of the properties of Nb3Sn and their variation with A15 composition, morphology and strain state. *Supercond. Sci. Technol.,* 2006, vol. 19, R77
- **J. W. EKIN.** Unified scaling law for flux pinning in practical superconductors: I. Separability postulate, raw scaling data and prameterization at moderate strains. *Supercond. Sci. Technol.,* 2010, vol. 23, 7